# EUROPEAN PATENT APPLICATION

(11) **EP 0 841 756 A2**
(43) Date of publication of application: **13.05.1998**
(21) Application number: 97308945.1
(22) Date of filing: 07.11.1997
(51) Int. Cl.: H04B 1/30, G01R 25/02

(54) **An improved correlator circuit for a six-port receiver**

(30) Priority: 07.11.1996 US 747022
(71) Applicant: NOKIA MOBILE PHONES LTD., 02150 Espoo (FI)
(72) Inventor: Hyyrylainen, Jari, 02880 Veikkola (FI); Ylamurto, Tommi, 02150 Espoo (FI)
(74) Representative: Haws, Helen Louise

(57) **Abstract**

A correlator circuit for a six port receiver wherein the received signal is summed with a local oscillator signal at various phase angles and wherein the phase rotation between the local oscillator and RF signals is carried out separately from the summing of the correlator outputs.

## Description

The present invention relates to six-port receivers employed in mobile telephones, and more particularly to an improved correlator structure for a six-port receiver.

A six-port receiver is a direct conversion receiver structure used in mobile telephones for in phase and quadrature component demodulation at microwave frequencies. The six-port structure uses power meters instead of conventional mixers. A received RF signal is summed with a local oscillator signal under various phase angles by devices such as microstrips in which the phase of both the RF signal and local oscillator signal properly changed. the basic six-port receiver including three quadrature hybrids and one power divider to determine the phase of a microwave signal was first described by S.B. Cohn and N.P. Wernhouse in the publication "An Automatic Microwave Phase Measurement System" Microwave Journal, Vol. 7, Feb. 1964. M. N. Solomon et al. in the publication "A Monolithic Six-Port Module", IEEE Microwave and Guided Wave Letters, Vol. 2, No. 8, Aug. 1992 describes a six-port device using a symmetrical five port and a power divider.

In the publication "A Six-Port Direct Digital Millimeter Wave Receiver" 1994 IEEE MTT-S Digest, JiLi et al. disclose a technique for direct microwave/mm wave digital phase demodulation using a six-port phase/frequency discriminator incorporated with a digital signal processing unit.

U.S. Patent 5,274,333 issued December 28, 1993 to Ghannovchi et al. entitled "FREQUENCY BALANCED SIX-PORT REFLECTOMETER WITH A VARIABLE TEST PORT IMPEDANCE" discloses a source of microwave power connected to the first, input, port of a six-port device whose second, output, port is connected to a device under test. A variable impedance is connected between the source and the input port.

Preferably, the variable impedance is a mechanical three stub tuner. The six-port device includes a first directional coupler whose first output comprises the output port. First, second and third hybrid couplers have outputs which constitute the third, fourth, fifth and sixth outputs of the six-port device. A power divider connects the directional coupler to the hybrid couplers.

U.S. Patent 5,170,126 issued December 8, 1992 to Wedge et al. entitled "MICROWAVE SIX-PORT NOISE PARAMETER ANALYZER" discloses a system for determining the noise parameters of a two-port electronic device under test that includes a six-port passive correlation network having two input ports and four output ports. Two noise sources are used, with each noise source being connected to separate input ports of the network using microwave circulators. One noise source is injected at the input port of the device under test while the other noise source is injected to the output port of the device under test. A power meter is selectively connectable to individual output ports of the network to detect the power level at the selected output port in response to predetermined noise signals from the noise sources. In the operation of the apparatus, the noise output from one noise source is held constant while the noise output from the noise source is varied. During this variation, the power meter reads power levels at the network output ports. The procedure is then repeated with the noise output from the one noise source being varied while the other is held constant. Again the power meter takes readings and the results are compared to obtain the noise parameters.

U.S. Patent 4,808,912 issued February 28, 1989 to Potter et al. entitled "SIX-PORT REFLECTOMETER TEST ARRANGEMENT AND METHOD INCLUDING CALIBRATION" discloses a test arrangement for testing high frequency electrical devices consisting of two 6-port reflectometers which are both connected to a device under test. In order to calibrate the test arrangement, an arbitrary termination generator is connected to each test port while its test signal represents a reflectivity coefficient of greater than unity, so that it simulates active devices as well as passive ones.

U.S. Patent 4,659,982 issued April 21, 1987 to Van de Velde et al. entitled "MICROWAVE APPARATUS AND METHOD OF OPERATION TO DETERMINE POSITION AND/OR SPEED OF A MOVABLE BODY OR DISCONTINUITY OR CHANGE IN A MATERIAL" discloses a system for constructing microwave systems and processing the signal by correlation is applicable notably to tachometric, telemetric, direction and tracking control systems, to the detection of heterogeneousness and discontinuity in materials by using sensors of the direct-contact or contactless type. The method, based on microwave radiation and utilizing microwave receiving aerials and at least one correlator, comprises the steps of emitting through a radiating aerial a single microwave radiation from a microwave source having predetermined characteristics; receiving the transmitted microwave by means of receiving aerials disposed at different locations; directing the signal thus received towards one or a plurality of correlators, and analyzing the frequency spectrum of the output signal of the correlator or correlators by using Fourier's transformed curve circuits or any other means capable of extracting the fundamental of the output signal or measuring the time elapsing between two passages through zero of the output signal.

U.S. Patent 4,571,545 issued February 18, 1986 to Griffin et al. entitled "SIX-PORT REFLECTOMETER" discloses a six-port reflectometer including first, second and third forward directional couplers to transmit power from a source for reflection at a measurement port. The couplers also divert incident and reflected wave samples for subsequent measurements. A fourth forward directional coupler receives samples of incident and reflected waves from the second coupler, the reflected waves being received directly and the incident waves via a waveguide appropriate to equalize wave path lengths. The first coupler is connected to a matched load and the third coupler to a short circuit. Power detectors are connected to the first, third and fourth couplers. The reflectometer has the band-width of its components.

One advantage of the present invention is to provide a six-port receiver for mobile telephones including an improved correlator circuit.

A second advantage of the present invention is to provide an improved correlator circuit for a six-port receiver wherein the received signal is combined with a local oscillator signal at various phase angles.

A third advantage of the present invention is to provide a correlator circuit for a six-port receiver wherein the phase information of the combined correlator outputs is not relevant to the power monitoring.

A fourth advantage of the present invention is to provide a correlator circuit for a six-port receiver wherein the phase rotation between the local oscillator and RF signals is carried out separately from the combining of the correlator outputs.

Other and further features, advantages and benefits of the invention will become apparent in the following description taken in conjunction with the following drawings. It is to be understood that the foregoing general description and the following detailed description are exemplary and explanatory but are not to be restrictive of the invention. The accompanying drawings which are incorporated in and constitute a part of this invention and, together with the description, serve to explain the principles of the invention in general terms. Like numerals refer to like parts throughout the disclosure.

Fig. 1 is a schematic block diagram illustrating a typical six-port receiver apparatus according to the prior art.

Fig. 2 is a schematic block diagram illustrating a correlator circuit for a six-port receiver according to the prior art.

Fig. 3 is a schematic block diagram illustrating an embodiment of a correlator circuit for a six-port receiver according to the principles of the present invention.

Fig. 4 is a schematic diagram of an embodiment of a one-stage polyphase circuit employed in the correlator circuit of Fig. 3 for local oscillator signal dividing.

Fig. 5 is a schematic diagram of an embodiment of a two-stage polyphase circuit employed in the correlator circuit of Fig. 3 for local oscillator signal dividing.

Fig. 6 is a schematic diagram of a digital circuit for generating local oscillator signals.

Fig. 7 is an illustration of signal waveforms associated with the digital circuit of Fig. 6.

Fig. 8 is a schematic of an emitter-coupled differential pair that can be employed as a combining circuit in Fig. 3.

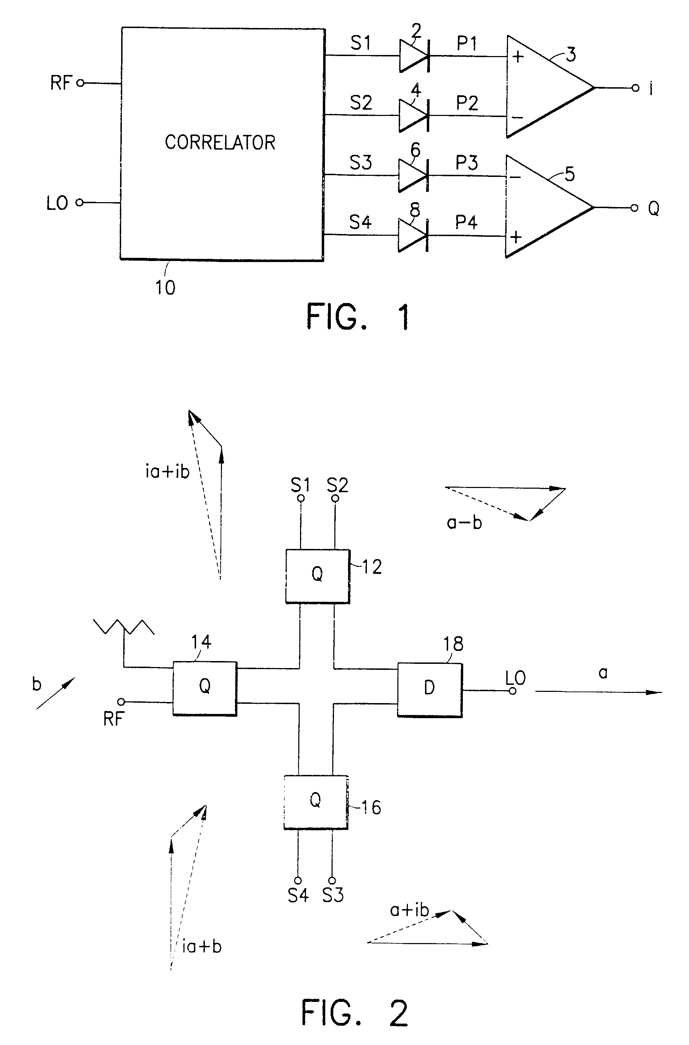

Referring to Fig. 1, the basic six-port receiver is illustrated including a correlator 10, the four phase and amplitude signals S1, S2, S3 and S4 which are applied to diode power detectors 2, 4, 6 and 8 and subtracting circuits 3 and 5 to provide I and Q quadrature signals.

Referring to Fig. 2, a phase discriminator or correlator circuit 10 for a six-port receiver that may be used in the system of Fig. 1 illustrated including three quadrature hybrids 12, 14 and 16 and one power divider 18. The RF voltage is designated "b" and the local oscillator voltage LO is designated "a" and the a and b voltages are combined to form four signal vectors S1, S2, S3 and S4 as shown in Fig. 2. The phase and amplitude information of the baseband signal is obtained from the power readings P1, P2, P3 and P4 which are obtained from the signals S1, S2, S3 and S4 by the aforesaid diode power detectors. The phase and amplitudes of the signals S1, S2, S3 and S4 are illustrated in Fig. 2 as vectors ia + ib, a-b, a + ib and ia + b respectively.

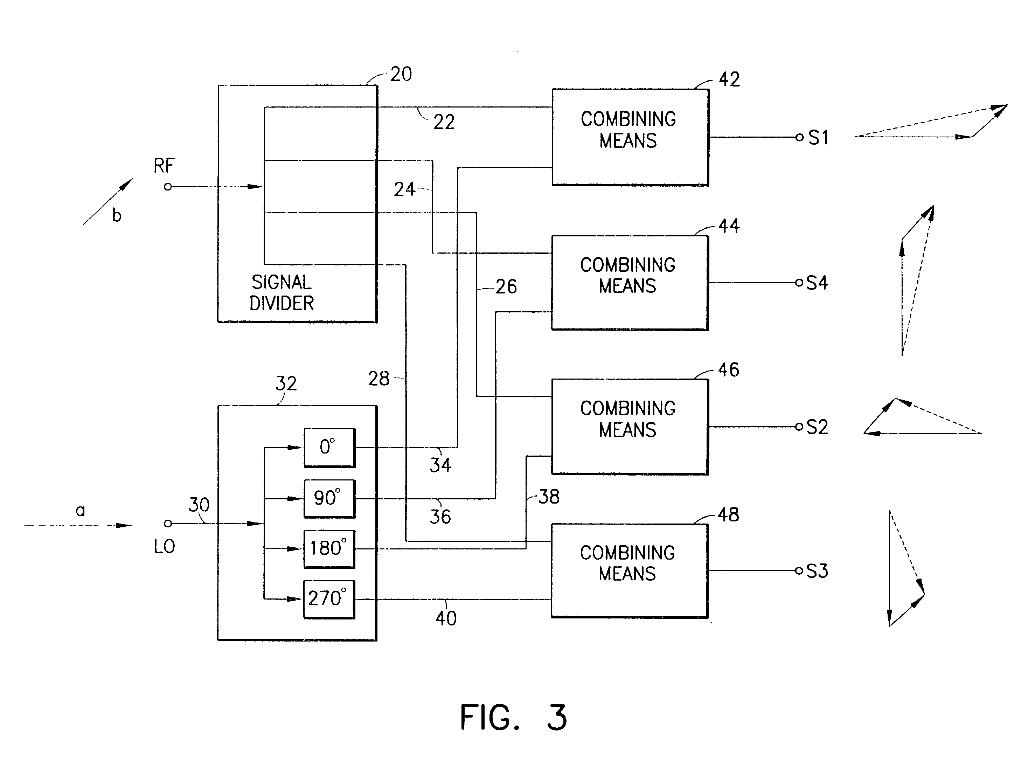

Fig. 3 illustrates an embodiment of a correlator structure for a six-port receiver according to the present invention. The RF signal b is applied to signal divider circuit 20 where it is divided into four equal parts on leads 22, 24, 26 and 28. The RF signal b can be divided into the four equal parts paths by using emitter follower circuits as buffers for each output to provide isolation between the four outputs of the divider 20.

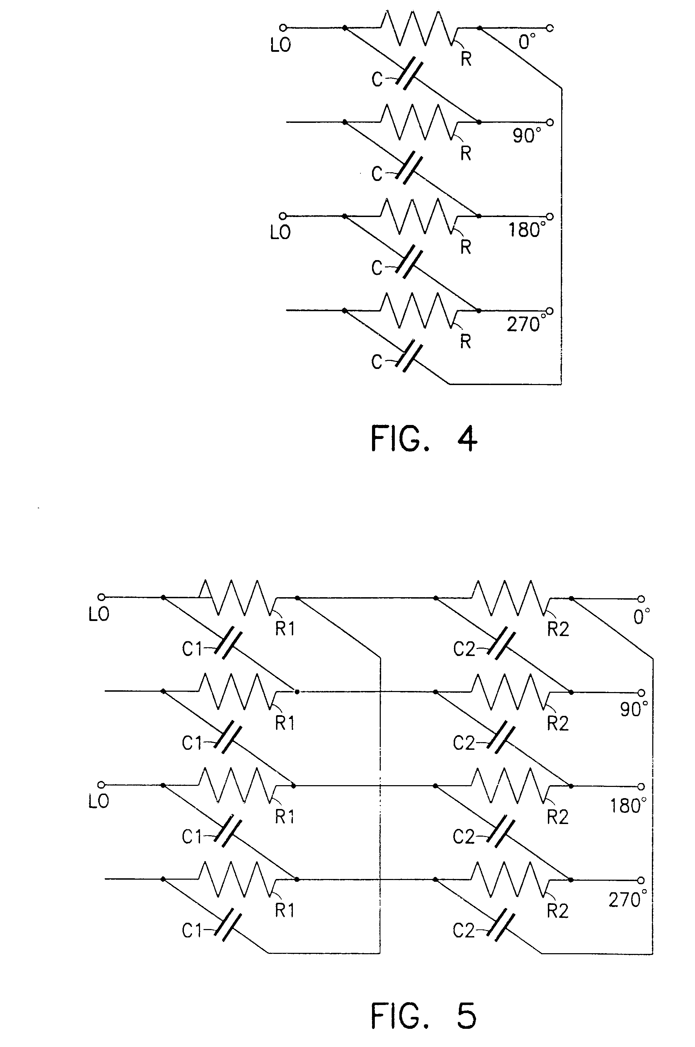

A polyphase circuit as illustrated in Fig. 4 can be used for LO reference signal dividing and phase shift generation. A polyphase circuit is normally used for quadrature signal generation in IQ-modulation and demodulation systems. A polyphase filter circuit can be used as a 90 deg. phase shifter. The idea of a polyphase is disclosed in the publication by M.J. Gingell. "Single Sideband Modulation Using Sequence Asymmetric Polyphase Networks", Electrical Communication, vol. 48, No. 1 and 2, pp. 21-25, 1973. The "sequence asymmetric polyphase filter" disclosed in the Gingell publication is a network, which has the same number of inputs and outputs, and the electrical path from each input terminal to its corresponding output terminal is identical. The phase balance of a polyphase circuit is good, typically better than 1 degree over an octave bandwidth. The amplitudes of the polyphase circuit branches are identical only on a narrow band. To achieve wider bandwidth more than one polyphase stage can be connected in series as illustrated in the two-stage circuit of Fig. 5. By appropriate dimensioning (time constants R₁C₁ and R₂C₂) better than 1dB amplitude balance and 6dB attenuation can be achieved over an octave bandwidth when using a two stage polyphase circuit.

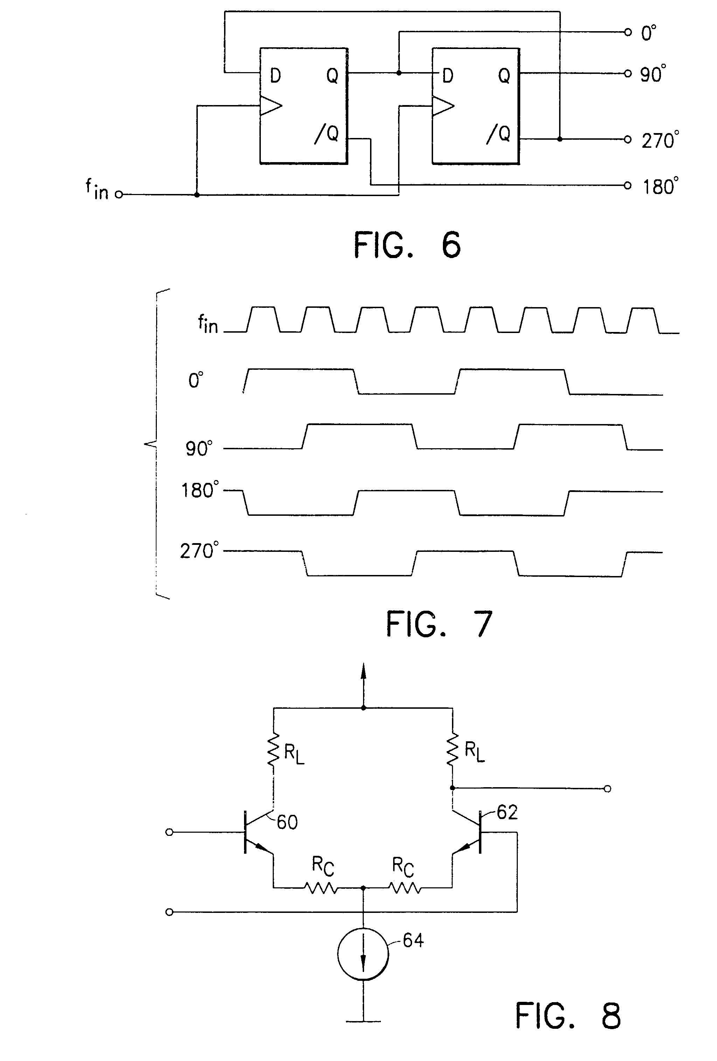

The dividing and phase shifting of the LO reference signals can also be generated by digital means. In Fig. 6 circuit is provided showing how this can be done by using two D-flip-flops. The circuit of Fig. 6 is also the type of a circuit used for quadrature signal generation. Here the input frequency fᵢₙ must be four times the needed LO reference. The waveforms for the four output signals for the circuit of Fig. 6 are illustrated in Fig. 7.

Referring to Fig. 3, the local oscillator LO reference signal a is applied on lead 30 to signal divider and phase rotation means 32 where it is divided into four equal signals that are rotated by 90 degrees, 180 degrees and 270 degrees to provide four signals on leads 34, 36, 38 and 40 that are spaced by ninety degrees.

Leads 22 and 34 are connected to combining means 42 where they are vector summed or subtracted to provide a signal S1 having a phase and amplitude as illustrated by the dotted line vector in Fig. 3. Likewise, the signals on leads 24 and 36 are connected to combining means 44, the signals on leads 26 and 38 are connected to combining means 46 and the signals on leads 28 and 40 are connected to combining means 48 to provide signals S4, S2 and S3 respectively as illustrated by the dotted line vectors in Fig. 3. A differential pair (an emitter-coupled pair) as illustrated in Fig. 8 can be used as the subtracting means 42, 44, 46 and 48 of Fig. 3. A differential pair is formed by two identical transistors 60 and 62 and a current source in the emitter lead. It should be noted that modulated the large dynamic range RF signal could be phase rotated instead of the LO signal, but it is less noisy to phase rotate the high power LO reference signal. It should be also noted that the amplitudes of the vector sum outputs S1, S2, S3 and S4 are the same as the amplitudes of the outputs S1, S2, S3 and S4 in Fig. 2. In the correlator embodiment of Fig. 3 however, a significant feature of the invention is that the relative phase relation between the signals "a" and"b" in phase rotation means 32 is done separately from the vector summing performed in summing means 42, 44, 46 and 48, because in the power monitoring function, the phase information of the combined vector sum outputs is not relevant.

The six-port correlator structure of the present invention is especially suitable for MMIC implementation. Division of RF can be done simply by branching the signal line into four parts. Four wanted LO signals can be made, for example, with polyphase circuit, as illustrated in Fig. 4. The combining of the RF and LO signals can be made with a differential pair.

While the invention has been described in connection with a preferred embodiment, it is not intended to limit the scope of the invention to the particular form set forth, but, on the contrary, it is intended to cover such alternatives, modifications, and equivalence as may be included within the spirit and scope of the invention as defined in the appended claims.

While the invention has been particularly shown and described with respect to preferred embodiments thereof, it will be understood by those skilled in the art that changes in form and details may be made therein without departing from the scope and spirit of the invention.

The scope of the present disclosure includes any novel feature or combination of features disclosed therein either explicitly or implicitly or any generalisation thereof irrespective of whether or not it relates to the claimed invention or mitigates any or all of the problems addressed by the present invention. The applicant hereby gives notice that new claims may be formulated to such features during prosecution of this application or of any such further application derived therefrom.

## Claims

1. A correlator circuit for a six-port receiver apparatus comprising:
a first input lead connected to an RF input signal,
a second input lead connected to a local oscillator signal,
a signal dividing means connecting one of said first and second input leads for dividing the signal thereon into first, second, third and fourth output signals,
a signal dividing and phase rotating means connected to the other of said first and second input leads for dividing the signal thereon into first, second, third and fourth equal signals and for phase rotating said signals to provide first, second, third and fourth equal output signals each 90 degrees apart in phase,
first, second, third and fourth combining means, said first combining means connected to said first output signal from said signal dividing means and said first output signal from said signal dividing and phase shifting means for providing a first vector sum output signal, said second combining means connected to said second output signal of said dividing means and said second output signal from said signal dividing and phase shifting means for providing a second vector sum output signal, said third combining means connected to said third output signal from said signal dividing means and said third output signal from said signal dividing and phase shifting means for providing a third vector sum output signal and said fourth combining means connected to said fourth output signal from said signal dividing means and said fourth output signal from said signal dividing and phase shifting means for providing a fourth vector sum output signal.

2. A correlator circuit according to claim 1, wherein said signal dividing means is connected to said first input lead for dividing said RF signal thereon and wherein said signal dividing and phase shifting means is connected to said second input signal for dividing and phase shifting said local oscillator signal thereon.

3. A correlator circuit as claimed in claim 1 or 2, wherein each of said first, second, third and fourth sector sum signals from said respective first, second, third and fourth combining means are connected respectively to first, second, third and fourth power detector or mixer circuits to provide first, second, third and fourth power signals, a first difference circuit connected to said first and second power signals for providing an I quadrature component output signal and a second difference circuit connected to said fourth and third power signals for providing a Q quadrature component output signal.

4. A correlator circuit as claimed in any preceding claim, wherein said signal dividing and phase rotating means is a polyphase circuit including first, second, third and fourth resistor components connected to said local oscillator signal,
and first, second, third and fourth capacitor components connected between said first and second, second and third, third and fourth and fourth and first resistor components respectively.

5. A correlator circuit according to claim 4 wherein said signal dividing and phase rotating means includes a second polyphase circuit stage comprising fifth, sixth, seventh and eighth resistor components connected in series with said first, second third and fourth resistor components respectively and fifth, sixth, seventh and eighth capacitor components connected between said fifth and sixth, sixth and seventh, seventh and eighth, and eighth and fifth resistor components respectively.

6. A correlator circuit as claimed in any of claims 1 to 3, wherein said signal dividing and phase rotating means is a digital circuit comprising first and second flip-flop devices.

7. A correlator circuit as claimed in any preceding claim, wherein said first, second third and fourth combining means each comprise a pair of emitters coupled differential transistors having emitter leads connected to a current source.

8. A correlator circuit comprising:
a signal dividing means for dividing a first input signal into four output signals;
a signal dividing means and phase rotating means for dividing a second input signal into four signals and for phase rotating the signals to provide four output signals each with a different respective phase rotation;
a combining means for combining each output signal from the signal dividing means with a respective one of the output signals from the signal dividing and phase rotational means to provide four vector sum output signals.
